# EUROPEAN PATENT APPLICATION

(11) **EP 4 411 844 A1**
(43) Date of publication of application: **07.08.2024**
(21) Application number: 22876066.6
(22) Date of filing: 22.09.2022
(51) Int. Cl.: H01L 33/50, F21S 2/00, F21V 9/32, F21Y 115/10

(54) **LIGHT EMITTING APPARATUS AND ILLUMINATION APPARATUS**

(30) Priority: 28.09.2021 JP 2021158465
(71) Applicant: Kyocera Corporation, Kyoto-shi Kyoto 612-8501 (JP)
(72) Inventor: KANCHIKU, Tsuyoshi, Kyoto-shi, Kyoto 612-8501 (JP); MIYAKE, Akira, Kyoto-shi, Kyoto 612-8501 (JP)
(74) Representative: Viering, Jentschura & Partner mbB Patent- und Rechtsanwälte
(86) International application number: PCT/JP2022/035505
(87) International publication number: WO 2023/054199

(57) **Abstract**

Alight emitting device (10) includes a substrate (2), a light emitting element (3), and a wavelength conversion member (6). The substrate (2) includes a first surface. The light emitting element (3) is mounted on the first surface of the substrate (2) and is configured to emit excitation light. The wavelength conversion member (6) is in contact with at least an entire end portion of the first surface of the substrate (2). The wavelength conversion member (6) includes a portion extending outward relative to at least part of the end portion of the first surface of the substrate (2) in plan view of the first surface of the substrate (2).

## Description

### CROSS-REFERENCE TO RELATED APPLICATIONS

This present application claims priority to Japanese Patent Application No. 2021-158465, filed on Sept. 28, 2021, which is hereby incorporated by reference herein in its entirety.

### TECHNICAL FIELD

The present disclosure relates to a light emitting device and an illumination apparatus.

### BACKGROUND OF INVENTION

A known optoelectronics device includes a support, a light emitting semiconductor chip, and a conversion member for wavelength conversion such that the semiconductor chip and the conversion member are located on the support (refer to Patent Literature 1, for example).

### CITATION LIST

### PATENT LITERATURE

Patent Literature 1: Japanese Unexamined Patent Application Publication No. 2019-50359

### SUMMARY

In an embodiment of the present disclosure, a light emitting device includes a substrate, a light emitting element, and a wavelength conversion member. The substrate includes a first surface. The light emitting element is located on the first surface of the substrate and is configured to emit excitation light. The wavelength conversion member is in contact with at least an entire end portion of the first surface of the substrate. The wavelength conversion member includes a portion extending outward relative to at least part of the end portion of the first surface of the substrate in plan view of the first surface of the substrate.

In an embodiment of the present disclosure, an illumination apparatus includes the light emitting device and a mounting board on which the light emitting element is mounted.

### BRIEF DESCRIPTION OF THE DRAWINGS

FIG. 1 is a plan view of an exemplary configuration of a light emitting device in an embodiment.
FIG. 2 is a sectional view taken along line A-A in FIG. 1.
FIG. 3 is a sectional view of an exemplary configuration of a substrate.
FIG. 4 is an enlarged view of part surrounded by a broken line in FIG. 2.
FIG. 5 is a sectional view of an exemplary configuration with a wavelength conversion member including a concave top surface.
FIG. 6 is a sectional view of an exemplary configuration with the wavelength conversion member including a beveled edge.
FIG. 7A is a sectional view of an exemplary section taken along the YZ plane.
FIG. 7B is a sectional view of an exemplary section taken along the ZX plane.
FIG. 8A is a diagram illustrating the wavelength conversion member pulled in a rotating direction of a blade during dicing and deformed.
FIG. 8B is a diagram illustrating the wavelength conversion member compressed by sides of the blade during dicing and deformed.
FIG. 9 is a perspective view of an exemplary configuration of an illumination apparatus in an embodiment.

### DESCRIPTION OF EMBODIMENTS

### (Exemplary Configuration of Light Emitting Device 10)

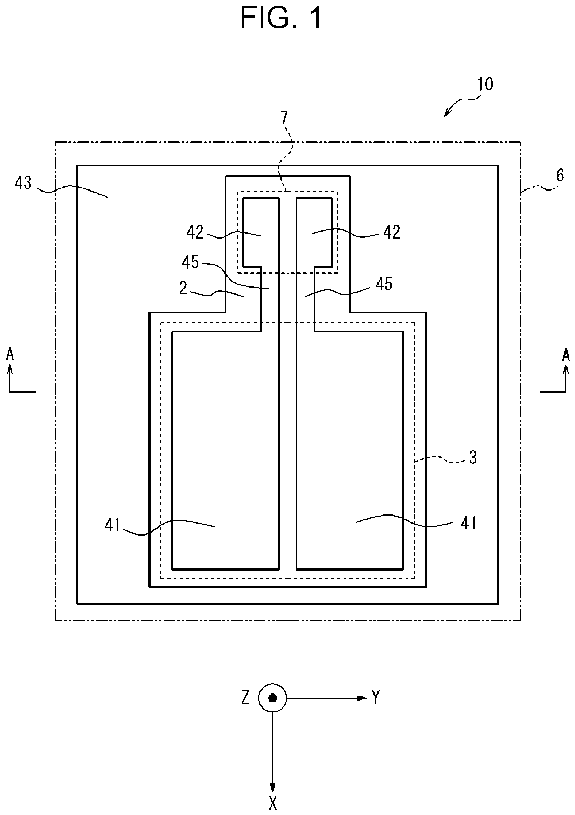

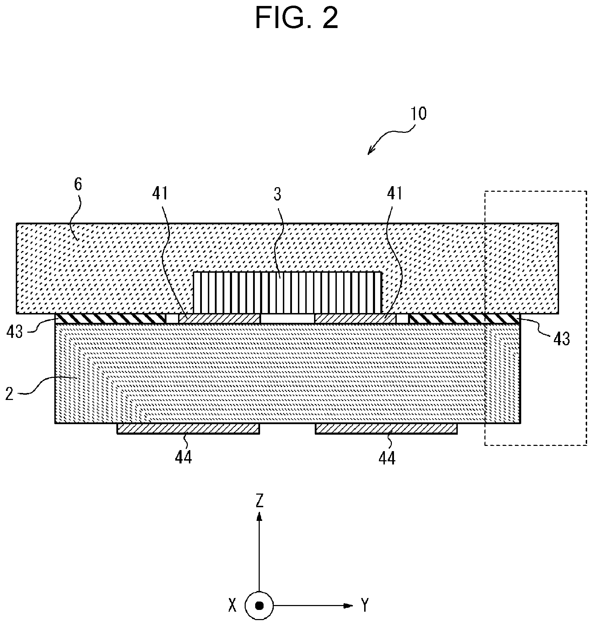

As illustrated in FIGs. 1, 2, and 3, a light emitting device 10 includes an element substrate 2, a light emitting element 3, and a wavelength conversion member 6. The light emitting element 3 is located on the positive side of the Z axis relative to the element substrate 2. The wavelength conversion member 6 is located on the positive side of the Z axis relative to the element substrate 2 and the light emitting element 3.

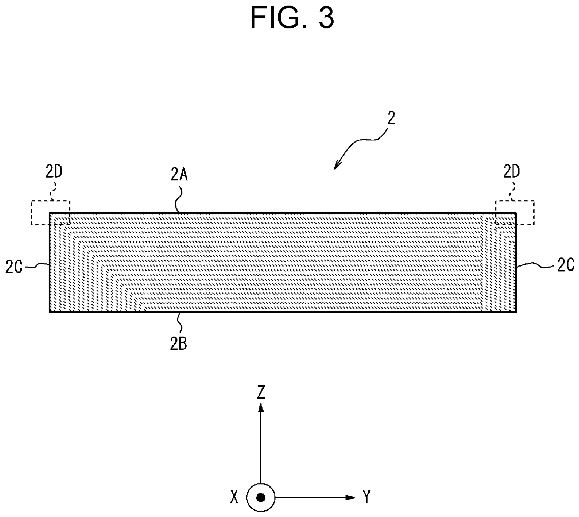

As illustrated in FIG. 3, the element substrate 2 includes a first surface 2A facing in the positive direction of the Z axis and a second surface 2B facing in the negative direction of the Z axis. A side of the element substrate 2 that faces in the positive direction of the Z axis will also be referred to as a front side. A side of the element substrate 2 that faces in the negative direction of the Z axis will also be referred to as a back side. The element substrate 2 further includes lateral faces 2C intersecting the first surface 2A and the second surface 2B. The lateral faces 2C of the element substrate 2 will also be referred to as substrate lateral sides. The first surface 2A includes sides intersecting the lateral faces 2C. The sides of the first surface 2A or an area at a predetermined distance from the sides will also be referred to as an end portion 2D of the first surface 2A.

The element substrate 2 includes a first electrode 41 and a second electrode 42 on the first surface 2A on the front side. The first electrode 41 is located on the positive side of the X axis relative to the second electrode 42. Two first electrodes 41 and two second electrodes 42 are arranged side by side along the Y axis. The first electrode 41 and the second electrode 42 on the positive side of the Y axis are electrically connected. The first electrode 41 and the second electrode 42 on the negative side of the Y axis are electrically connected. In other words, the element substrate 2 includes two electrodes each including the first electrode 41 and the second electrode 42 connected. The element substrate 2 includes two back electrodes 44 on the second surface 2B on the back side. The two electrodes located on the front side are electrically connected to the two back electrodes 44 located on the back side by wiring lines extending through the element substrate 2. Specifically, one electrode located on the positive side of the Y axis on the front side is electrically connected to one back electrode 44 located on the positive side of the Y axis on the back side. One electrode located on the negative side of the Y axis on the front side is electrically connected to one back electrode 44 located on the negative side of the Y axis on the back side.

The element substrate 2 further includes a reflective member 43, which extends across an area with no electrodes on the first surface 2A on the front side. The reflective member 43 extends over the end portion 2D of the first surface 2A. In plan view of the first surface 2A of the element substrate 2, the reflective member 43 surrounds the light emitting element 3.

The light emitting element 3 is electrically connected to the first electrodes 41. The light emitting element 3 is operated by power supplied from the back electrodes 44 to the first electrodes 41. The light emitting element 3 emits light having a peak wavelength in a wavelength range of, for example, from 360 nm to 430 nm. The wavelength range of from 360 nm to 430 nm is also referred to as a violet region.

The wavelength conversion member 6 converts light emitted from the light emitting element 3 and incident on the wavelength conversion member 6 into light having a peak wavelength in a wavelength range of, for example, from 360 nm to 780 nm and emits the converted light. A wavelength range of from 360 nm to 950 nm is referred to as a visible region. The wavelength conversion member 6 is excited by light emitted from the light emitting element 3, thereby emitting light having a peak wavelength in the visible region. Light that the light emitting element 3 emits is also referred to as excitation light. The light emitting element 3 included in the light emitting device 10 is also referred to as an excitation-light emitting element.

The light emitting device 10 may further include an electronic component 7. The electronic component 7 may be, for example, a Schottky diode. The electronic component 7 is electrically connected to the second electrodes 42. The electronic component 7 is capable of controlling a voltage across the two electrodes located on the front side. The first electrodes 41 and the second electrodes 42 are connected by connecting conductor paths 45.

Concrete examples of the components of the light emitting device 10 will be described below.

### <Element Substrate 2>

The element substrate 2 will also be simply referred to as a substrate. The element substrate 2 may be made of, for example, an insulating material. The element substrate 2 may be made of, for example, a ceramic material such as aluminum oxide (alumina) or mullite, a glass ceramic material, or a composite material that is a mixture of several of these materials. The element substrate 2 may be made of a polymeric resin material containing dispersed metal oxide particles capable of adjusting thermal expansion. The element substrate 2 may contain aluminum nitride or silicon carbide. This can improve the thermal conductivity of the element substrate 2, leading to improved heat dissipation performance of the light emitting device 10. In the present embodiment, the element substrate 2 is made of aluminum nitride.

The first electrodes 41, the second electrodes 42, the back electrodes 44, and the wiring lines extending through the element substrate 2 may be made of, for example, a conductive material such as tungsten, molybdenum, manganese, or copper. The reflective member 43 may be made of, for example, a silicone-resin-based material containing, as an additive, a white material such as titanium oxide. The reflective member 43 is not limited to this example. The reflective member 43 may be formed such that the reflectivity of the reflective member 43 is higher than that of the first surface 2A. The reflective member 43 located on the first surface 2A makes excitation light emitted from the light emitting element 3 and illumination light converted by the wavelength conversion member 6 less likely to be absorbed by the first surface 2A. Thus, excitation light and illumination light can be emitted to the outside of the light emitting device 10 with high efficiency.

### <Light Emitting Element 3>

The light emitting element 3 is a light emitting diode (LED), which emits light to the outside when electrons recombine with holes in a P-N junction between P-type and N-type semiconductor materials. The light emitting element 3 is not limited to an LED, and may be any other light emitting device.

The light emitting element 3 is mounted on the first surface 2A of the element substrate 2. The light emitting element 3 is electrically connected to the first electrodes 41 located on the first surface 2A of the element substrate 2 with, for example, braze or solder. The two first electrodes 41, which are paired with each other, are connected to a positive electrode and a negative electrode of the light emitting element 3. In transparent plan view of the first surface 2A of the element substrate 2, the light emitting element 3 is located on the first electrodes 41 to cover at least part of each of the first electrodes 41. The light emitting element 3 may be larger than the first electrodes 41 in transparent plan view.

The light emitting element 3 may be mounted on the element substrate 2 by flip-chip bonding. For the light emitting element 3 mounted in a flip-chip bonding manner, the first electrodes 41 and braze, solder, or the like are covered with the light emitting element 3 in plan view of the first surface 2A. Covering the first electrodes 41 and braze, solder, or the like with the light emitting element 3 makes excitation light emitted from the light emitting element 3 or illumination light converted by the wavelength conversion member 6 less likely to enter the first electrodes 41 and braze, solder, or the like. Thus, excitation light or illumination light is less likely to be absorbed by the first electrodes 41 and braze, solder, or the like. This may further enhance the efficiency of light emission of the light emitting device 10.

For the light emitting element 3 mounted on the element substrate 2 in a wire bonding manner as a comparative example, at least part of a wire is not covered by the light emitting element 3. In this case, excitation light or illumination light may be absorbed by the wire. In the embodiment, the light emitting device 10 includes the light emitting element 3 mounted on the element substrate 2 in a flip-chip bonding manner. Such a configuration makes excitation light or illumination light less likely to be absorbed than in the comparative example using wire bonding. This can further enhance the efficiency of light emission of the light emitting device 10.

The number of light emitting elements 3 mounted on the first surface 2A of the element substrate 2 is one in FIG. 1, for example. The number of light emitting elements 3 is not limited to this example, and may be two or more. In a case where the number of light emitting elements 3 is two or more, the light emitting elements 3 are disposed without overlapping each other in plan view of the first surface 2A.

The light emitting element 3 may include a translucent base and an opto-semiconductor layer formed on the translucent base. The translucent base contains a material that allows the opto-semiconductor layer to be deposited thereon by using a chemical vapor deposition method, such as a metal-organic chemical vapor deposition method or a molecular beam epitaxial deposition method. The translucent base may be made of, for example, sapphire, gallium nitride, aluminum nitride, zinc oxide, zinc selenide, silicon carbide, silicon (Si), or zirconium diboride. The translucent base may have a thickness of, for example, from 50 µm to 1000 µm.

The opto-semiconductor layer may include a first semiconductor layer formed on the translucent base, a light emitting layer formed on the first semiconductor layer, and a second semiconductor layer formed on the light emitting layer. The first semiconductor layer, the light emitting layer, and the second semiconductor layer may be made of, for example, a Group III nitride semiconductor, a Group III-V semiconductor such as gallium phosphide or gallium arsenide, or a Group III nitride semiconductor such as gallium nitride, aluminum nitride, or indium nitride.

The first semiconductor layer may have a thickness of, for example, from 1 µm to 5 µm. The light emitting layer may have a thickness of, for example, from 25 nm to 150 nm. The second semiconductor layer may have a thickness of, for example, from 50 nm to 600 nm.

### <Wavelength Conversion Member 6>

The wavelength conversion member 6 is located on the first surface 2A of the element substrate 2. The wavelength conversion member 6 occupies a space on the light emitting element 3 to enclose the light emitting element 3. The wavelength conversion member 6 may be formed by applying the wavelength conversion member 6 in paste form to the first surface 2A of the element substrate 2 and curing the paste. The wavelength conversion member 6 may also be formed by sticking the wavelength conversion member 6 in sheet form to the first surface 2A of the element substrate 2 and curing the sheet.

Excitation light emitted from the light emitting element 3 directly enters the wavelength conversion member 6. The wavelength conversion member 6 converts the entered excitation light into light having a peak wavelength in a wavelength range of, for example, from 360 nm to 780 nm, and emits the converted light.

The wavelength conversion member 6 may include a translucent member and phosphors.

The translucent member may be made of, for example, a light-transmissive insulating resin material, such as fluorocarbon resin, silicone resin, acrylic resin, or epoxy resin, or a light-transmissive glass material. The translucent member may have an index of refraction of, for example, from 1.4 to 1.6.

The phosphors are contained in the translucent member. The phosphors may be substantially uniformly dispersed in the translucent member. The phosphors convert incident excitation light into light having various peak wavelengths.

The phosphors may convert excitation light into light identified by a spectrum having a peak wavelength in a wavelength range of, for example, from 400 nm to 500 nm, or blue light. In this case, examples of materials for the phosphors may include BaMgAl₁₀O₁₇:Eu, (Sr, Ca, Ba)₁₀(PO₄)₆Cl₂:Eu, and (Sr, Ba)₁₀(PO₄)₆Cl₂:Eu.

The phosphors may convert excitation light into light identified by a spectrum having a peak wavelength in a wavelength range of, for example, from 450 nm to 550 nm, or blue-green light. In this case, examples of materials for the phosphors may include (Sr, Ba, Ca)₅(PO₄)₃Cl:Eu and Sr₄Al₁₄O₂₅:Eu.

The phosphors may convert excitation light into light identified by a spectrum having a peak wavelength in a wavelength range of, for example, from 500 nm to 600 nm, or green light. In this case, examples of materials for the phosphors may include SrSiz(O, Cl)₂N₂:Eu, (Sr, Ba, Mg)₂SiO₄:Eu²⁺, Zns:Cu, Al, and Zn₂SiO₄:Mn.

The phosphors may convert excitation light into light identified by a spectrum having a peak wavelength in a wavelength range of, for example, 600 nm to 700 nm, or red light. In this case, examples of materials for the phosphors may include Y₂O₂S:Eu, Y₂O₃:Eu, SrCaClAlSiN₃:Eu²⁺, CaAlSiN₃:Eu, and CaAlSi(ON)₃:Eu.

The phosphors may convert excitation light into light identified by a spectrum having a peak wavelength in a wavelength range of, for example, from 680 nm to 800 nm, or near-infrared light. The near-infrared light may include light in a wavelength range of from 680 to 2500 nm. In this case, examples of materials for the phosphors may include 3Ga₅O₁₂:Cr.

The wavelength conversion member 6 may contain any combination of types of phosphor. Materials for the phosphors are not limited to the above-described materials, and may include other various materials.

As described above, excitation light that has entered the wavelength conversion member 6 from the light emitting element 3 is converted into light having a peak wavelength that depends on the phosphors. The peak wavelength of the converted light may be included in the visible region. The converted light may have different peak wavelengths depending on combination of phosphors included in the wavelength conversion member 6. For example, in a case where the phosphors contain a material that emits blue fluorescence, a material that emits blue-green fluorescence, a material that emits green fluorescence, the converted light has peak wavelengths in the blue, blue-green, and green wavelength ranges. In a case where the phosphors contain only one type of material, the converted light has a peak wavelength determined by the material. The phosphors are not limited to these examples, and may contain various combinations of materials. The color of light emitted from the wavelength conversion member 6 is determined based on the type of material contained in the phosphors. In other words, the converted light may have different spectra.

In the embodiment, the light emitting device 10 can emit light having different spectra based on combinations of materials contained in the phosphors. The light emitting device 10 can emit light with, for example, the spectrum of direct sunlight from the sun, the spectrum of sunlight at a predetermined depth in the sea, the spectrum of light from a candle flame, or the spectrum of firefly light. In other words, the light emitting device 10 can emit light with different colors. The light emitting device 10 can emit light with different color temperatures.

The wavelength conversion member 6 is located on the first surface 2A of the element substrate 2. In plan view of the first surface 2A, the wavelength conversion member 6 extends over the sides of the first surface 2A at which the first surface 2A intersects the lateral faces 2C. The wavelength conversion member 6 is in contact with at least part of the first surface 2A. In a portion of the first surface 2A at which the reflective member 43 is located, the wavelength conversion member 6 is in contact with the first surface 2A with the reflective member 43 therebetween. The wavelength conversion member 6 may be in direct contact with the first surface 2A of the element substrate 2 or may be in contact with the first surface 2A with the reflective member 43 therebetween.

The wavelength conversion member 6 is in contact with at least the entire end portion 2D of the first surface 2A. The entire end portion 2D of the first surface 2A corresponds to the perimeter or the sides of the first surface 2A at which the first surface 2A intersects the lateral faces 2C. The wavelength conversion member 6 in contact with the end portion 2D of the first surface 2A ensures that excitation light reflected by the first surface 2A or the reflective member 43 passes through the wavelength conversion member 6. This can enhance the efficiency of excitation light conversion. Furthermore, the wavelength conversion member 6 includes a portion extending outward relative to at least part of the end portion 2D of the first surface 2A in plan view of the first surface 2A. The portion of the wavelength conversion member 6 extending outward relative to the end portion 2D of the first surface 2A can increase a length traveled by excitation light through the wavelength conversion member 6. This can enhance the efficiency of excitation light conversion.

The first surface 2A of the element substrate 2 may have a rectangular shape. The shape of the first surface 2A is not limited to a rectangle, and may be any other polygon. The shape of the first surface 2A may be a figure with a curved perimeter, such as a circle or an ellipse. The wavelength conversion member 6 may extend outward relative to each of the sides of the first surface 2A of the element substrate 2. If the shape of the first surface 2A of the element substrate 2 is rectangular, the wavelength conversion member 6 may have a rectangular cuboid shape. This can increase a length traveled by excitation light through the wavelength conversion member 6. This can enhance the efficiency of excitation light conversion. All of outer edges of the wavelength conversion member 6 may be located outside the respective sides of the element substrate 2. This can reduce a likelihood that the element substrate 2 may be broken due to a direct impact of an external mechanical pressure applied to the light emitting device 10. This can reduce a malfunction of the light emitting device 10. Furthermore, the wavelength conversion member 6 has a lower elastic modulus than the element substrate 2. This can reduce a likelihood that the light emitting device 10 may be broken under an external mechanical pressure.

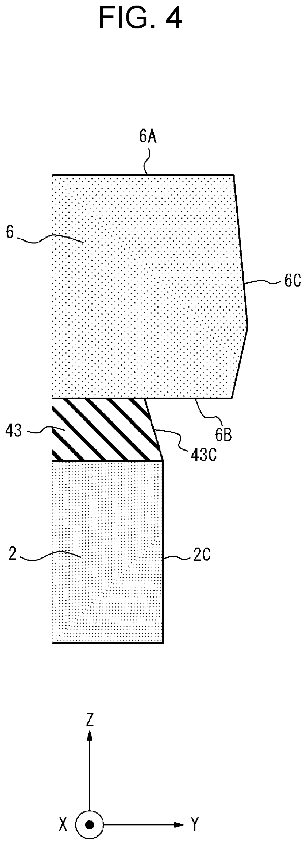

As illustrated in FIG. 4, the wavelength conversion member 6 includes a top surface 6A facing in the positive direction of the Z axis, a bottom surface 6B facing in the negative direction of the Z axis, and lateral faces 6C intersecting the top surface 6A and the bottom surface 6B. The lateral faces 6C will also be referred to as wavelength-conversion-member lateral faces. The wavelength-conversion-member lateral faces may protrude outward relative to the wavelength conversion member 6 in sectional view of the element substrate 2 taken along at least one face thereof that intersects the first surface 2A. The protruding wavelength-conversion-member lateral faces can increase a distance traveled by excitation light through the wavelength conversion member 6. This can enhance the efficiency of excitation light conversion.

The portion of the wavelength conversion member 6 extending outward relative to the end portion 2D of the first surface 2A of the element substrate 2 may have different shapes at opposite sides of the wavelength conversion member 6 in sectional view of the element substrate 2. In other words, in sectional view of the element substrate 2 taken along at least one face thereof that intersects the first surface 2A, the shapes of opposite sides of the portion of the wavelength conversion member 6 extending outward relative to the end portion 2D of the first surface 2A of the element substrate 2 may be asymmetric with respect to a center line that passes through the center of the wavelength conversion member 6 and extends in a stacking direction in which the element substrate 2 and the wavelength conversion member 6 are stacked. Specifically, the portion of the wavelength conversion member 6 extending outward may protrude by different amounts. The lateral faces 6C of the wavelength conversion member 6 may have different shapes.

In the light emitting device 10, the lateral faces 6C (wavelength-conversion-member lateral faces) of the wavelength conversion member 6 may have a larger surface roughness than the lateral faces 2C (substrate lateral faces) of the element substrate 2. This can reduce the impact of an external mechanical pressure on the light emitting device 10 to reduce the likelihood of breakage of the light emitting device 10. As long as the surface roughness of the lateral faces 6C (wavelength-conversion-member lateral faces) of the wavelength conversion member 6 and the surface roughness of the lateral faces 2C (substrate lateral faces) of the element substrate 2 are measured by using the same measurement method and criteria, a method of measurement in a contact or non-contact manner may be appropriately selected based on sizes, materials, and the like in conformity with standards. Usable examples of methods of measurement in a contact manner include scanning with a stylus. Usable examples of methods of measurement in a non-contact manner include light interferometry, composition of images with shifted focal points, and measurement with a confocal microscope.

The reflective member 43 includes lateral faces 43C extending continuously from the lateral faces 2C of the element substrate 2. The lateral faces 43C of the reflective member 43 will also be referred to as reflective-member lateral faces. The reflective-member lateral faces slope inward from the sides, at which the first surface 2A of the element substrate 2 intersects the lateral faces 2C, of the first surface 2A in a direction to the wavelength conversion member 6. In other words, the reflective-member lateral faces slope inward on the first surface 2A of the element substrate 2 in a direction away from the first surface 2A of the element substrate 2. The sloping reflective-member lateral faces increase a probability that excitation light emitted from the bottom surface 6B of the wavelength conversion member 6 will be reflected by the reflective-member lateral faces and enter the bottom surface 6B of the wavelength conversion member 6. This can enhance the efficiency of excitation light conversion.

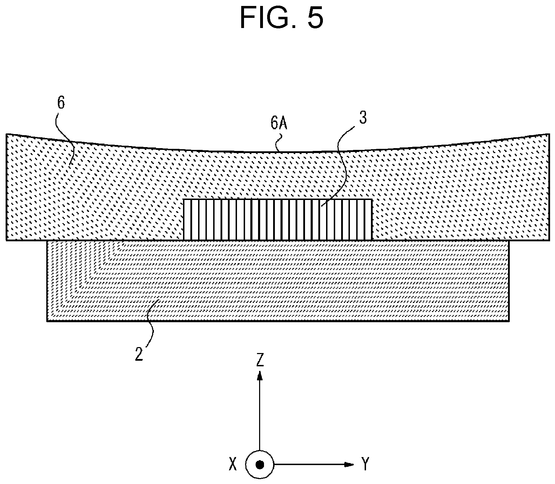

As illustrated in FIG. 5, the top surface 6A of the wavelength conversion member 6 may be a concave surface. In other words, the wavelength conversion member 6 may include a concave surface recessed toward the first surface 2A of the element substrate 2 in a portion of the wavelength conversion member 6 that coincides with at least the light emitting element 3 in plan view of the first surface 2A of the element substrate 2. The concave top surface 6A of the wavelength conversion member 6 facilitates collection of illumination light emitted from the top surface 6A of the wavelength conversion member 6 at the center of the concave surface.

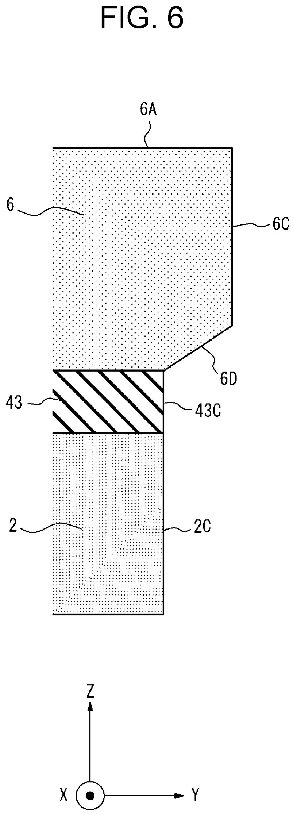

As illustrated in FIG. 6, the portion of the wavelength conversion member 6 extending outward relative to the end portion 2D of the first surface 2A of the element substrate 2 may include beveled edges at which the bottom surface 6B intersects the lateral faces 6C. In other words, the portion of the wavelength conversion member 6 extending outward relative to the end portion 2D of the first surface 2A of the element substrate 2 may include beveled edges adjacent to the first surface 2A of the element substrate 2 in sectional view of the element substrate 2 taken along at least one face thereof that intersects the first surface 2A. Each of the beveled edges may be a chamfered edge 6D, as illustrated in FIG. 6, or a rounded edge. This can reduce a likelihood that the portion of the wavelength conversion member 6 extending outward relative to the element substrate 2 may bend downward and deform under the weight of the wavelength conversion member.

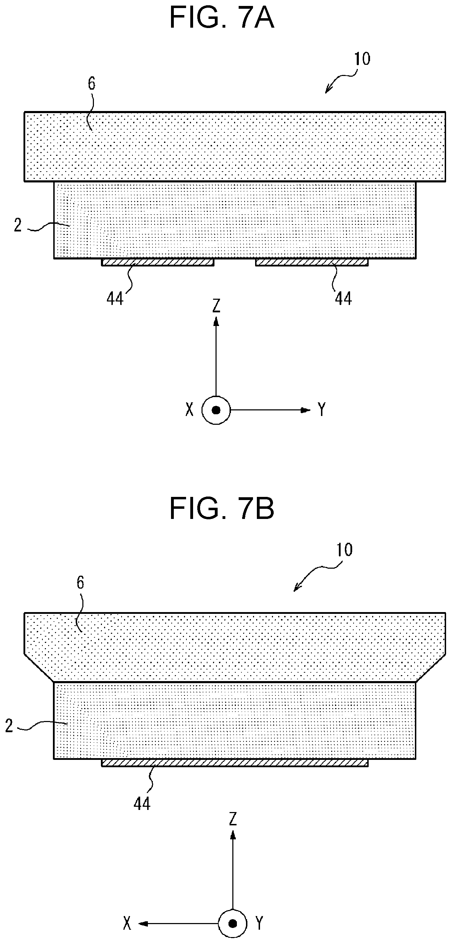

As illustrated in FIGs. 7A and 7B, the edges of the wavelength conversion member 6 may differ in shape depending on the direction of sectional view. As illustrated in FIG. 7A, the wavelength conversion member 6 includes no beveled edges in sectional view of the light emitting device 10 taken along the YZ plane. On the other hand, as illustrated in FIG. 7B, the wavelength conversion member 6 includes the beveled edges in sectional view of the light emitting device 10 taken along the ZX plane. This can maintain a balance between reducing the likelihood that the portion of the wavelength conversion member 6 extending outward relative to the element substrate 2 may bend downward and deform under the weight of the wavelength conversion member and enhancing the efficiency of light emission.

In sectional view of the element substrate 2 taken along at least one face thereof that intersects the first surface 2A, the portion of the wavelength conversion member 6 extending outward relative to the end portion 2D of the first surface 2A of the element substrate 2 may have a length greater than or equal to 1% and less than or equal to 5% of the length of the element substrate 2 in the same sectional view. Adjusting the length in this manner can adjust the size of the light emitting device 10. A length greater than or equal to 1% can reduce the likelihood that the element substrate 2 may be broken due to a direct impact of an external mechanical pressure applied to the light emitting device 10. A length less than or equal to 5% can reduce the likelihood that the portion of the wavelength conversion member 6 extending outward relative to the element substrate 2 may bend downward and deform under the weight of the wavelength conversion member. The term "length" as used herein refers to a maximum length of the portion of the wavelength conversion member 6 extending outward relative to the end portion 2D of the element substrate 2 in a direction along the first surface 2A, for example.

As illustrated in FIG. 1, the area of the light emitting element 3 may be larger than the area of the first electrodes 41 in plan view of the first surface 2A of the element substrate 2. The light emitting element 3 larger than the first electrodes 41 can reduce light that enters the first electrodes 41 having a low reflectivity. This can enhance the efficiency of light emission of the light emitting device 10. The light emitting element 3 may completely cover the first electrodes 41 in plan view of the first surface 2A of the element substrate 2. The light emitting element 3 covering the first electrodes 41 can reduce light that enters the first electrodes 41 having a low reflectivity. This can enhance the efficiency of light emission of the light emitting device 10.

The area of the electronic component 7 may be larger than the area of the second electrodes 42 in plan view of the first surface 2A of the element substrate 2. The electronic component 7 may completely cover the second electrodes 42. The wiring lines connecting the first electrodes 41 and the second electrodes 42 may be at least partly covered with the light emitting element 3 or the electronic component 7 or may be exposed in plan view of the first surface 2A of the element substrate 2.

In the embodiment, as described above, the wavelength conversion member 6 of the light emitting device 10 can be configured in various shapes. Adjusting the shape of the wavelength conversion member 6 can enhance the efficiency of excitation light conversion in the wavelength conversion member 6 or the efficiency of light emission of the light emitting device 10.

### (Effects of Dicing on Geometry of Wavelength Conversion Member 6)

In the embodiment, the light emitting device 10 is one of light emitting devices manufactured by, for example, forming a plurality of light emitting devices on a wafer and dicing the wafer. The geometry of the lateral faces 6C of the wavelength conversion member 6 or the lateral faces 2C of the element substrate 2 can be adjusted under conditions of dicing.

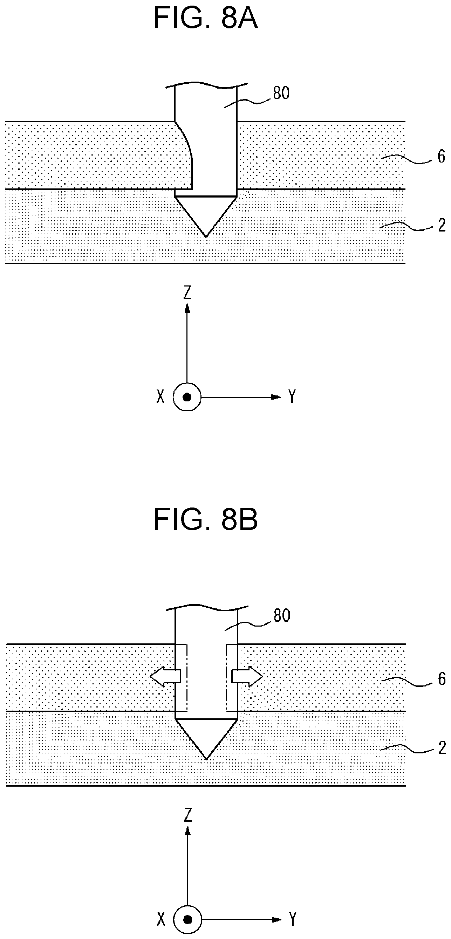

Dicing is performed in such a manner that a rotating disc-shaped blade 80 is placed on an object. As illustrated in FIG. 8A, the wavelength conversion member 6 may be pulled in a rotating direction in which the dicing blade 80 rotates. After the blade 80 passes through the wavelength conversion member 6, the wavelength conversion member 6 pulled in the rotating direction of the blade 80 returns to its original position. On the other hand, the element substrate 2, which has a higher elastic modulus than the wavelength conversion member 6, is less pulled in the rotating direction of the blade 80. Thus, a dicing cut in the wavelength conversion member 6 may have a width smaller than the width of a dicing cut in the element substrate 2.

As illustrated in FIG. 8B, the dicing blade 80 may proceed with cutting the wavelength conversion member 6 while pressing sides of the blade 80 onto the wavelength conversion member 6. In this case, the wavelength conversion member 6 is compressed in directions normal to the sides of the blade 80. After the blade 80 passes through the wavelength conversion member 6, the wavelength conversion member 6 pressed by the sides of the blade 80 returns to its original position. On the other hand, the element substrate 2, which has a higher elastic modulus than the wavelength conversion member 6, is less pulled in the rotating direction of the blade 80. Thus, a dicing cut in the wavelength conversion member 6 may have a width smaller than the width of a dicing cut in the element substrate 2.

A smaller width of the dicing cut in the wavelength conversion member 6 causes the wavelength conversion member 6 to include a portion extending outward relative to the end portion 2D of the first surface 2A of the element substrate 2. The difference in width between the dicing cut in the wavelength conversion member 6 and the dicing cut in the element substrate 2 can be adjusted based on the difference in elastic modulus between the wavelength conversion member 6 and the element substrate 2. The length of the portion of the wavelength conversion member 6 extending outward relative to the end portion 2D of the first surface 2A of the element substrate 2 can be adjusted based on the difference in elastic modulus between the wavelength conversion member 6 and the element substrate 2. Since the wavelength conversion member 6 has a lower elastic modulus than the element substrate 2, the wavelength conversion member 6 can be controlled to include a portion extending outward relative to the end portion 2D of the first surface 2A of the element substrate 2.

The conditions of dicing include a rotation speed of the dicing blade 80, a velocity at which the blade 80 is placed in the wavelength conversion member 6 and the element substrate 2, and the geometry of the blade 80. The geometry of the blade 80 is determined by, for example, the diameter, width, or surface roughness of the blade 80. The conditions of dicing are also determined by determining whether to cut the wafer in the direction along the X axis or the Y axis first in order to separate the light emitting devices 10 on the wafer. The geometry of the lateral faces 2C of the wavelength conversion member 6, the geometry of the lateral faces 43C of the reflective member 43, or the geometry of the lateral faces 2C of the element substrate 2 can be adjusted under the conditions of dicing. For example, the surface roughness of the lateral faces 6C of the wavelength conversion member 6 or the surface roughness of the lateral faces 2C of the element substrate 2 can be adjusted. The protrusions of the lateral faces 6C of the wavelength conversion member 6 can be adjusted. The geometry of the beveled edges of the wavelength conversion member 6 adjacent to the first surface 2A of the element substrate 2 can be adjusted.

### (Exemplary Configuration of Illumination Apparatus 100)

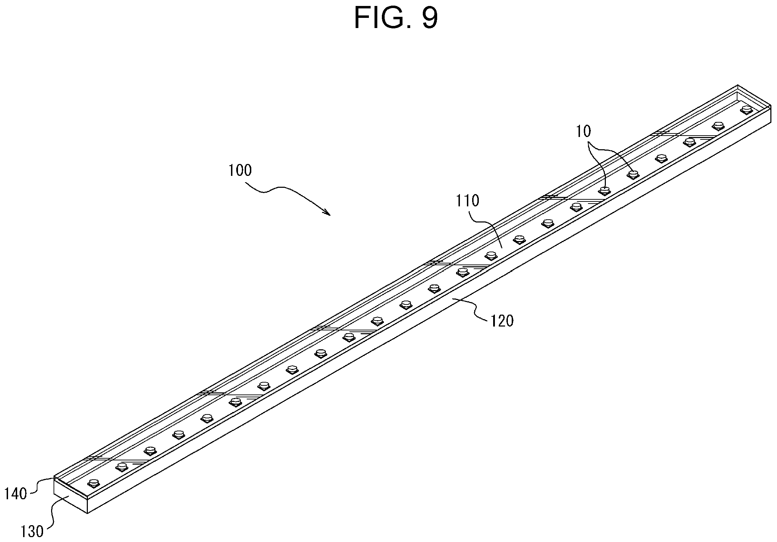

In an embodiment, as illustrated in FIG. 9, an illumination apparatus 100 includes at least one light emitting device 10 and emits, as illumination light, light emitted by the light emitting device 10. If the illumination apparatus 100 includes multiple light emitting devices 10, the intensities of light beams emitted by the respective light emitting devices 10 may be controlled individually or in association with each other. The light beams emitted by the respective light emitting devices 10 may have the same spectrum or may have spectra different from each other. The illumination apparatus 100 may control the intensities of light beams emitted by the respective light emitting devices 10 in association with each other to control the spectrum of light formed by combining light beams emitted from the respective light emitting devices 10. The light formed by combining light beams emitted from the respective light emitting devices 10 will also be referred to as combined light. The illumination apparatus 100 may emit combined light as illumination light. The illumination apparatus 100 may select at least a subset of the multiple light emitting devices 10 to emit illumination light.

The illumination apparatus 100 may further include a mounting board 110 on which the light emitting device 10 is mounted. The illumination apparatus 100 may further include a housing 120 and two ends plates 130. The housing 120 includes a groove holding the mounting board 110. The end plates 130 close lateral ends of the housing 120. The number of light emitting devices 10 mounted on the mounting board 110 may be one or two or more. The light emitting devices 10 mounted on the mounting board 110 may be aligned in a row or may be arranged in a grid pattern or a staggered pattern. The pattern of arrangement of the light emitting devices 10 is not limited to such examples. The light emitting devices 10 may be mounted on the mounting board 110 in various arrangement patterns.

The mounting board 110 may include a circuit board with a wiring pattern. The circuit board may include a printed circuit board, such as a rigid printed circuit board, a flexible printed circuit board, or a rigid-flexible printed circuit board. The circuit board may include a drive circuit that controls the light emitting device 10.

The mounting board 110 has a function of diffusing heat from the light emitting device 10 to the outside. The mounting board 110 may be made of, for example, a metallic material such as aluminum, copper, or stainless steel, an organic resin material, or a composite material containing such materials.

The mounting board 110 may have an elongated rectangular shape in plan view. The shape of the mounting board 110 is not limited to this example. The mounting board 110 may have any of other various shapes.

The illumination apparatus 100 may further include a lid 140, which covers the mounting board 110 and the light emitting device 10 in the housing 120. The lid 140 may be made of a translucent material, which allows illumination light emitted by the light emitting device 10 to be transmitted to the outside of the illumination apparatus 100. The lid 140 may be made of, for example, a resin material, such as acrylic resin, or glass. The lid 140 may have an elongated rectangular shape in plan view. The shape of the lid 140 is not limited to this example. The lid 140 may have any of other various shapes. The illumination apparatus 100 may further include a seal located between the lid 140 and the housing 120. This makes it difficult for water, dust, or the like to enter the housing 120. This can improve the reliability of the illumination apparatus 100 regardless of an environment where the illumination apparatus 100 is installed. The illumination apparatus 100 may further include a hygroscopic agent in the housing 120.

The figures illustrating the embodiments of the present disclosure are schematic. For example, a dimensional ratio in the figures does not necessarily match the actual one.

Although the present disclosure has been described with reference to the drawings and embodiments, the embodiments are not intended to be construed as limiting the present disclosure. It should be noted that those skilled in the art can easily make a variety of variations and alterations based on the present disclosure. Therefore, it should be noted that these variations and alterations are included in the scope of the present disclosure. For example, functions included in each component can be rearranged without logical inconsistency. For example, a plurality of components can be combined into one or divided. Other changes can be made without departing from the spirit and scope of the present disclosure.

In the present disclosure, terms "first", "second", and the like are descriptors to distinguish between the components. In the present disclosure, the descriptors representing numbers for the components distinguished with the terms "first", "second", and the like are interchangeable. For example, the descriptors "first" and "second" of the first surface 2A and the second surface 23 are interchangeable with each other. The descriptors are interchanged simultaneously. After the descriptors are interchanged, the components are distinguished from each other. The descriptors may be removed. The components with the descriptors removed are distinguished from each other by using reference signs. In the present disclosure, the description of descriptors such as "first", "second", and the like should not be used as a basis for interpreting the order of the components or the existence of descriptors representing smaller numbers.

In the present disclosure, the X axis, the Y axis, and the Z axis are provided for convenience of description and may be interchanged with each other. In the present disclosure, the configurations have been described by using the orthogonal coordinate system including the X axis, the Y axis, and the Z axis. In the present disclosure, the positional relationship between the components is not limited to an orthogonal relationship.

### REFERENCE SIGNS

10 light emitting device
2 element substrate (2A: first surface, 2B: second surface, 2C: lateral face, 2D: end portion)
3 light emitting element
6 wavelength conversion member (6A: top surface, 6B: bottom surface, 6C: lateral face, 6D: chamfered edge)
7 electronic component
41 first electrode
42 second electrode
43 reflective member
44 back electrode
45 connecting conductor path
80 dicing blade
100 illumination apparatus (110: mounting board, 120: housing, 130: end plate, 140: lid)

## Claims

1. Alight emitting device comprising:
a substrate including a first surface;
a light emitting element on the first surface of the substrate, the light emitting element being configured to emit excitation light; and
a wavelength conversion member in contact with at least an entire end portion of the first surface of the substrate,
wherein the wavelength conversion member includes a portion extending outward relative to at least part of the end portion of the first surface of the substrate in plan view of the first surface of the substrate.

2. The light emitting device according to claim 1,
wherein the first surface of the substrate has a rectangular shape, and
wherein the wavelength conversion member includes a portion extending outward relative to respective sides of the first surface of the substrate.

3. The light emitting device according to claim 2, wherein all of outer edges of the wavelength conversion member are located outside outer edges of the first surface of the substrate.

4. The light emitting device according to any one of claims 1 to 3,
wherein the substrate includes a reflective member on the first surface, the reflective member surrounding the light emitting element, and
wherein the wavelength conversion member is in contact with the end portion of the first surface of the substrate with the reflective member located between the wavelength conversion member and the end portion.

5. The light emitting device according to claim 4,
wherein the reflective member includes a reflective-member lateral face extending continuously from a lateral face of the substrate, and
wherein the reflective-member lateral face slopes inward on the first surface of the substrate in a direction away from the first surface of the substrate.

6. The light emitting device according to any one of claims 1 to 5, wherein the portion of the wavelength conversion member extending outward relative to the end portion of the first surface of the substrate has different shapes at opposite sides of the wavelength conversion member in sectional view of the substrate taken along at least one face of the substrate that intersects the first surface.

7. The light emitting device according to any one of claims 1 to 6,
wherein the substrate includes a substrate lateral face intersecting the first surface,
wherein the wavelength conversion member includes a wavelength-conversion-member lateral face intersecting a surface of the wavelength conversion member that extends along the first surface of the substrate, and
wherein the substrate lateral face has a smaller surface roughness than the wavelength-conversion-member lateral face.

8. The light emitting device according to any one of claims 1 to 7, wherein the wavelength conversion member includes a concave surface recessed toward the first surface of the substrate in a portion of the wavelength conversion member that coincides with at least the light emitting element in plan view of the first surface of the substrate.

9. The light emitting device according to any one of claims 1 to 8, wherein, in sectional view of the substrate taken along at least one face of the substrate that intersects the first surface, the portion of the wavelength conversion member extending outward relative to the end portion of the first surface of the substrate includes a chamfered or rounded edge adjacent to the first surface of the substrate.

10. The light emitting device according to any one of claims 1 to 9, wherein the wavelength conversion member has a rectangular cuboid shape.

11. The light emitting device according to any one of claims 1 to 10, wherein the wavelength conversion member has a lower elastic modulus than the substrate.

12. The light emitting device according to any one of claims 1 to 11, wherein, in sectional view of the substrate taken along at least one face of the substrate that intersects the first surface, the portion of the wavelength conversion member extending outward relative to the end portion of the first surface of the substrate has a length greater than or equal to 1% and less than or equal to 5% of a length of the substrate in the sectional view of the substrate.

13. The light emitting device according to any one of claims 1 to 12,
wherein the wavelength conversion member includes a wavelength-conversion-member lateral face intersecting a surface of the wavelength conversion member that extends along the first surface of the substrate, and
wherein, in sectional view of the substrate taken along at least one face of the substrate that intersects the first surface, the wavelength-conversion-member lateral face protrudes outward.

14. The light emitting device according to any one of claims 1 to 13,
wherein the substrate includes a first electrode on the first surface, the first electrode being configured to supply power to the light emitting element, and
wherein, in plan view of the first surface of the substrate, the light emitting element has a larger area than the first electrode.

15. The light emitting device according to claim 14, wherein, in plan view of the first surface of the substrate, the light emitting element completely covers the first electrode.

16. The light emitting device according to claim 14 or 15,
wherein the substrate includes a second electrode located on the first surface and electrically connected to the first electrode, the second electrode being configured to supply power to an electronic component different from the light emitting element, and
wherein, in plan view of the first surface of the substrate, the electronic component has a larger area than the second electrode.

17. An illumination apparatus comprising:
the light emitting device according to any one of claims 1 to 16; and
a mounting board on which the light emitting device is mounted.
